# EUROPEAN PATENT SPECIFICATION

(11) **EP 4 629 789 B1**
(45) Date of publication and mention of the grant of the patent: **02.09.2026**
(21) Application number: 25167555.9
(22) Date of filing: 31.03.2025
(51) Int. Cl.: H10F 77/70, H10F 77/20, H10F 77/30

(54) **BACK CONTACT SOLAR CELL, PHOTOVOLTAIC MODULE**
RÜCKKONTAKTSOLARZELLE, PHOTOVOLTAIKMODUL
CELLULE SOLAIRE À CONTACT ARRIÈRE, MODULE PHOTOVOLTAÏQUE

(30) Priority: 03.04.2024 CN 202410406325
(43) Date of publication of application: 08.10.2025
(73) Proprietor: Zhejiang Jinko Solar Co., Ltd., Haining, Zhejiang 314416 (CN); Jinko Solar (Haining) Co., Ltd., Haining City, Zhejiang (CN)
(72) Inventor: JIANG, Lilin, Haining, 314416 (CN); LI, Huimin, Haining, 314416 (CN); XU, Menglei, Haining, 314416 (CN); YANG, Jie, Haining, 314416 (CN)
(74) Representative: Balder IP Law, S.L.

(56) References cited:
- CN-U- 218 975 458
- KR-A- 20140 021 125
- US-A1- 2024 088 312

## Description

### TECHNICAL FIELD

Embodiments of the present disclosure relate to the technical field of photovoltaic manufacturing, and in particular to a back contact solar cell and a photovoltaic module.

### BACKGROUND

The back contact solar cell, also known as interdigitated back contact (IBC) solar cell, is a type of back contact solar cell. The most prominent feature of IBC solar cells is that the emitter region electrode and the base region electrode are both located on the back surface of the cell, reducing shading. Compared to solar cells with shading on the light-receiving surface, IBC cells have higher short-circuit current and photoelectric conversion efficiency.

Due to the absence of obstructions on the front surface, IBC cells eliminate losses caused by shading of electrode fingers, maximizing the utilization of incident photons. Accordingly, the back surface of the cell needs to form p+ and n+ regions arranged in an interdigitated pattern, and further needs to form gap regions between the p+ and n+ regions for separating the p+ and n+ regions and preventing short circuit in the cell. At present, the structure of the back surface of the IBC cell is complicated, affecting the deposition and formation of subsequent film layers on the back surface of the cell, and further affecting the passivation performance of the cell.

How to improve the passivation performance while improving the efficiency of IBC cells is a technical issue that needs to be addressed.

The following document is relevant for understanding the context of the invention: US 2024/088312 A1 discloses a photovoltaic cell including a substrate having a front surface with metal pattern regions and a rear surface, first pyramid structures in each metal pattern region, platform protrusion structures on the rear surface, a first tunneling layer and a first doped conductive layer on a portion of the front surface in a respective metal pattern region, and a second tunneling layer and a second doped conductive layer on the rear surface. A height of each first pyramid structure is greater than that of each platform protrusion structure. A one-dimensional dimension of a bottom portion of each first pyramid structure is less than that of each platform protrusion structure. A doping element type of the first doped conductive layer is the same as that of the substrate. A doping element type of the second doped conductive layer is different from that of the first doped conductive layer.

### SUMMARY

The present invention is set out in the appended set of claims.

### BRIEF DESCRIPTION OF THE DRAWINGS

Fig. 1 is a schematic structural view of a back contact solar cell provided in an embodiment of the present disclosure;
Fig. 2 is an enlarged structural view of portion A in Fig. 1;
Fig. 3 is an enlarged structural view of portion B in Fig. 1;
Fig. 4 is a schematic structural view of an N-type conductive region with first texture structures provided in an embodiment of the present disclosure;
Fig. 5 is a schematic structural view of a P-type conductive region with second texture structures provided in an embodiment of the present disclosure;
Fig. 6 is a microscope image of the first texture structures provided in an embodiment of the present disclosure;
Fig. 7 is a microscope image of the second texture structures provided in the embodiment of the present disclosure;
Fig. 8 is a flow chart of the preparation of the back contact solar cell provided in an embodiment of the present disclosure; and
Fig. 9 is a schematic structural view of a photovoltaic module provided in an embodiment of the present disclosure.

Reference numerals in the accompanying drawings are listed as follows:
1 semiconductor substrate;
2 N-type conductive region;
   21 first texture structure;
3 P-type conductive region;
   31 second texture structure;
4 gap region;
5 first passivation layer;
6 second passivation layer;
7 first electrode;
8 second electrode;
1000 photovoltaic module;
   100 back contact solar cell;
   200 first cover plate;
   300 first encapsulation adhesive layer;
   400 second encapsulation adhesive layer;
   500 second cover plate.

The drawings herein are incorporated into the specification and constitute a part of the specification, show embodiments consistent with the present disclosure, and together with the description explain the principles of the present disclosure.

### DETAILED DESCRIPTION OF THE EMBODIMENTS

To make the objectives, technical solutions, and advantages of the present disclosure clearer, the following further describes the present disclosure in detail with reference to the accompanying drawings and the embodiments. It should be understood that the specific embodiments described herein are only used to explain the present disclosure and are not intended to limit the present disclosure.

In the description of the present disclosure, unless otherwise specified or limited, the terms "first" and "second" are used for descriptive purposes only and should not be understood as indicating or implying relative importance. Unless otherwise specified or indicated, the term "multiple/plurality of" refers to two or more. The terms "connection", "fixation", etc. should be understood in a broad sense. For example, "connection" may refer to a fixed connection, a detachable connection, an integral connection, or an electrical connection; it may be directly connected or indirectly connected through an intermediary. For those of ordinary skill in the art, the specific meanings of the above terms in the present disclosure should be understood according to the specific circumstances.

In the description of this specification, it should be understood that the directional terms such as "up" and "down" described in the embodiments of the present disclosure are described from the perspective shown in the accompanying drawings, and should not be understood as limitation to the embodiments of the present disclosure. In addition, it should also be understood that when it is described that an element is connected to another element, the former element cannot only be directly connected to the another element, but also can be indirectly connected to the another element through an intermediate element.

In related technologies, during the preparation process of IBC cells, the back surface process involves the formation of interdigitated p+ and n+ regions through phosphorus and boron diffusion. Specifically, boron diffusion is firstly performed on the back surface of the silicon substrate to form an n+ doped layer, and then a portion of the n+ doped layer is removed by local laser ablation. Then, phosphorus diffusion is performed in the region where the n+ doped layer is removed to form a p+ doped layer. After that, etching and pickling are performed to form a gap region between the n+ doped layer and the p+ doped layer. The gap region is generally in the shape of a groove and is used to prevent recombination issues in the area where the n+ doped layer and the p+ doped layer contact. As the rear surface of the IBC cell generally needs to be polished or texturized to form certain texture structures, that is, the n+ doped layer, gap region, and p+ doped layer on the back surface of the cell are all formed with texture structures, the texture structures can effectively reduce the reflectivity of the silicon substrate surface and increase light absorption, thereby improving the photoelectric conversion efficiency of the cell. In addition, the existence of the texture structures can also affect the passivation performance of the cell. Currently, the texture structures of the rear surface of the IBC cell has limited improvement on the passivation performance and light absorption of the cell. Therefore, there is a need to improve the IBC cell.

In view of the above, the embodiments of the present disclosure provide a back contact solar cell, which includes: a semiconductor substrate 1 having a front surface and a rear surface opposing each other. An N-type conductive region 2 and a P-type conductive region 3 are arranged on the rear surface of the semiconductor substrate 1. The N-type conductive region 2 has a plurality of first texture structures 21. The P-type conductive region 3 has a plurality of second texture structures 31. The first texture structures 21 include two adjacent first texture structures 21 that are different at least in height. The second texture structures 31 include two adjacent second texture structures 31 that are different at least in height. A height of the first texture structures 21 is less than a height of the second texture structures 31. A one-dimensional dimension of the first texture structures 21 is greater than a one-dimensional dimension of the second texture structures 31. The back contact solar cell further includes a first passivation layer 5 located on the front surface of the semiconductor substrate 1; a second passivation layer 6 located on the rear surface of the semiconductor substrate 1; a first electrode 7 passing through the second passivation layer 6 and forming an ohmic contact with the P-type conductive region 3; and a second electrode 8 passing through the second passivation layer 6 and forming an ohmic contact with the N-type conductive region 2.

In the above solution, the present disclosure designs texture structures of different sizes for the N-type conductive region 2 and the P-type conductive region 3, respectively. The N-type conductive region 2 is doped with N-type elements, and the P-type conductive region 3 is doped with P-type elements. The N-type conductive region 2 has multiple first texture structures 21, and the P-type conductive region 3 has multiple second texture structures 31. The first texture structures 21 include two adjacent first texture structures 21 that are different at least in height, and the second texture structures 31 include two adjacent second texture structures 31 that are different at least in height. A height of the first texture structures 21 is less than a height of the second texture structures 31, and a one-dimensional dimension of the first texture structures 21 is greater than a one-dimensional dimension of the second texture structures 31, which can reduce the recombination of minority carriers in the N-type conductive region 2 and improve the passivation quality of the N-type conductive region 2, thereby improving the interface recombination at the back surface of the cell. Moreover, the first texture structures can improve the contact characteristics between the paste at the back surface of the cell and the semiconductor substrate 1, and can also reduce parasitic absorption of sunlight in the N-type conductive region 2. The height of the second texture structures 31 of the P-type conductive region 3 is relatively large, and the one-dimensional dimension of the second texture structures 31 is relatively small, which allows more sunlight to be scattered and captured in the P-type conductive region 3, thereby reducing light loss and improving the light absorption efficiency of the back surface of the cell. In addition, the N-type conductive region 2 and the P-type conductive region 3 of the present disclosure are designed to have texture structures of different sizes , which can reduce the electrode contact resistance of the first electrode 7 and the second electrode 8 on the back surface, thereby improving the passivation performance of the cell and improving the overall performance of the cell. The present disclosure designs the size of the texture structures of different regions on the back surface of the cell, which can simultaneously improve the conversion efficiency and passivation performance of the cell, thereby improving the overall performance of the cell.

In the present disclosure, the height of the first texture structures 21 refers to a distance from the top of the first texture structures 21 to the bottom of the first texture structures 21 along a thickness direction of the semiconductor substrate 1. It can be understood that the top of the first texture structures 21 and the bottom of the first texture structures 21 oppose each other, and the bottom of the first texture structures 21 is in contact with the N-type conductive region 2. Correspondingly, the height of the second texture structures 31 refers to a distance from the top of the second texture structures 31 to the bottom of the second texture structures 31 along the thickness direction of the semiconductor substrate 1. Preferably, the first and second texture structures are recessed structures recessed towards an interior of the substrate. In the solar cell of the present disclosure, the first texture structures 21 include two adjacent first texture structures 21 that are different at least in height, and the second texture structures 31 include two adjacent second texture structures 31 that are different at least in height, a height of the first texture structures 21 being less than a height of the second texture structures 31. The semiconductor substrate 1 with the N-type conductive region 2 and the P-type conductive region 3 in the solar cell is cut and placed under a measuring instrument (optical microscope, atomic force microscope, scanning electron microscope, transmission electron microscope, etc.) for observation. The observation angle is along the thickness direction of the semiconductor substrate 1 after cutting, and it can be observed from the measuring instrument that the overall height of the first texture structures 21 of the N-type conductive region 2 is different from the overall height of the second texture structures 31 of the P-type conductive region 3, and the first texture structure 21 and the second texture structures 31 have a significant height difference.

In the present disclosure, the one-dimensional dimension of the first texture structures 21 refers to the length, width, diagonal length, and diameter of the circle, of the bottom surface of the first texture structures 21, which is not limited here. The one-dimensional dimension of the first texture structures 21 can be calibrated directly by measuring the film surface with a measuring instrument (optical microscope, atomic force microscope, scanning electron microscope, transmission electron microscope, etc.). Correspondingly, the one-dimensional dimension of the second texture structures 31 refers to the length, width, diagonal length, diameter of the circle, of the bottom surface of the second texture structures 31. The one-dimensional dimension of the second texture structures 31 can be measured by the above-mentioned measuring instrument.

In the present disclosure, the P-type conductive region 3 refers to a region formed by highly doped P-type semiconductor material, and the N-type conductive region 2 refers to a region formed by highly doped N-type semiconductor material. The P-type conductive region 3 and the N-type conductive region 2 are distributed in an interdigitated manner on the rear surface of the semiconductor substrate 1 for separating and collect carriers. The P-type conductive region 3 is used to collect holes, and the N-type conductive region 2 is used to collect electrons. Then, the collected carriers are transferred to the electrodes on the rear surface of the semiconductor substrate 1 and together with external loads to form a circuit. Therefore, the P-type conductive region 3 and the N-type conductive region 2 cannot be in direct contact, otherwise the collected carriers will directly contact and form a short circuit on the rear surface of the semiconductor substrate 1, and the carriers cannot be effectively collected. Therefore, a "groove-like" gap region 4 is generally formed between the P-type conductive region 3 and the N-type conductive region 2.

It should be noted that the semiconductor substrate 1 generally has a front surface and a rear surface. The front surface of the semiconductor substrate 1 may refer to a light-receiving surface, which is the surface that receives sunlight, and the rear surface of the semiconductor substrate 1 may refer to the surface opposite the front surface.

In some embodiments, the semiconductor substrate 1 is an N-type crystalline silicon substrate (or silicon wafer), and may also be a P-type crystalline silicon substrate (silicon wafer). The crystalline silicon substrate (silicon substrate) is, for example, one of polycrystalline silicon substrate, monocrystalline silicon substrate, microcrystalline silicon substrate, or silicon carbide substrate. The specific type of the semiconductor substrate 1 is not limited in the embodiments of the present disclosure. In the case that the semiconductor substrate 1 is an N-type substrate, the doping element may be a group V element such as phosphorus (P), arsenic (As), or tellurium (Te). The N-type semiconductor substrate 1 and the P-type conductive region 3 form a PN junction, and the N-type semiconductor substrate 1 and the N-type conductive region 2 form an NN+ high-low junction. In the case that the semiconductor substrate 1 is a P-type substrate, the doping element may be a group III element such as boron (B), aluminum (Al), or gallium (Ga). The P-type semiconductor substrate 1 and the N-type conductive region 2 form a PN junction, and the P-type semiconductor substrate 1 and the P-type conductive region 3 form a PP+ high-low junction.

In the present disclosure, "texture structure" refers to micro-nano-scale structures that can scatter or reflect light to enhance light absorption. The texture structure of the present disclosure can be formed by chemical etching, laser etching, machining, or plasma etching the semiconductor substrate 1.

In some embodiments, the morphology of the first texture structures 21 includes a non-pyramid shape. Compared to the pyramid-shaped morphology, the non-pyramid-shaped texture structure is beneficial for the formation of the subsequent film layer on the semiconductor substrate 1 during the preparation of solar cells, which can lead to higher passivation quality. The non-pyramid-shaped texture structure has better contact characteristics with the paste, allowing the screen-printing metal paste to better fill it when forming the electrode, leading to better electrode contact, higher open-circuit voltage and fill factor, and thus higher cell conversion efficiency. Correspondingly, the morphology of the second texture structures 31 includes a non-pyramid shape.

In some embodiments, the morphology of the bottom surface of the first texture structure 21 includes at least one of diamond, square, trapezoid, approximate diamond, approximate square, and approximate trapezoid. The morphology of the bottom surface of the second texture structure 31 includes at least one of diamond, square, trapezoid, approximate diamond, approximate square, and approximate trapezoid.

The "height" or "one-dimensional dimension" of the aforementioned texture structures is typically determined through the following method: collecting 3 to 5 samples with diameters of approximately 1 to 2 cm from the central and edge regions of the solar cell; placing each sample under the measuring instrument and selecting 3 to 5 fields of view in both the central and edge areas of the sample; measuring the height or one-dimensional dimension of 5 to 20 texture structures within each field of view; and calculating the average value of the height or one-dimensional dimension across all sampled textured structures. The average value is defined as the "height" or "one-dimensional dimension" of the multiple textured structures.

In some embodiments, the one-dimensional dimension of the first texture structure 21 is less than or equal to 40 nm. For example, it can be 5nm, 10nm, 15nm, 20nm, 25nm, 30nm, 33nm, 38nm, or 40nm. Preferably, the one-dimensional dimension of the first texture structure 21 is less than or equal to 30 nm. Further preferably, the one-dimensional dimension of the first texture structure 21 is less than or equal to 25nm.

In some embodiments, the one-dimensional dimension of the second texture structure 31 is less than or equal to 30 nm. For example, it can be 3nm, 8nm, 10nm, 15nm, 22nm, 25nm, 28nm, or 30nm. Preferably, the one-dimensional dimension of the second texture structure 31 is less than or equal to 20nm. Further preferably, the one-dimensional dimension of the second texture structure 31 is less than or equal to 25nm.

Compared to the second texture structures 31, the one-dimensional dimension of the first texture structures 21 is larger, allowing more sunlight to be scattered and captured in the P-type conductive region 3, reducing light loss and improving the light absorption ability of the back surface at the second texture structures 31. Further, the long-wave light incident from the front surface of the cell can also achieve a higher light absorption effect in the P-type conductive region 3, thereby improving the conversion efficiency of the cell. Compared to the first texture structures 21, the one-dimensional dimension of the second texture structures 31 is smaller, the number of second texture structures 31 in the P-type conductive region 3 is larger, the height of the second texture structures 31 of the P-type conductive region 3 is smaller, and the one-dimensional dimension of the second texture structures 31 is smaller, which can reduce the recombination of minority carriers in the N-type conductive region 2, improve the passivation quality of the N-type conductive region 2, and further improve the interface recombination at the back surface of the cell. Moreover, the smaller sized second texture structures 31 can improve the contact characteristics between the paste at the back surface of the cell and the semiconductor substrate 1.

In some embodiments, a height difference between a height of the first texture structures 21 and a height of the second texture structures 31 ranges from 0.5µm to 5µm. For example, the height difference can be 0.5µm, 1µm, 2µm, 3µm, 4µm, or 5µm. The height difference being in the above-mentioned range allows the back surface of the semiconductor substrate 1 to exhibit a structure where high parts and low parts are arranged alternatingly. The height of the second texture structures 31 is smaller, allowing the P-type conductive region 3 to obtain excellent passivation effect and form good contact with the electrode paste, which is beneficial to improving the open-circuit voltage and fill factor, thereby obtaining excellent conversion efficiency. In addition, configuring the height of the first texture structures 21 and the height of the second texture structures 31 to be different is beneficial for the alignment of the first electrode 7 and the second electrode 8 on the back surface of the cell.

In some embodiments, the height of the first texture structures 21 ranges from 0µm to 8µm. For example, it can be 0µm, 0.5µm, 1µm, 2µm, 3µm, 4µm, 5µm, 6µm, 7µm or 8µm. Preferably, the height of the first texture structures 21 ranges from 0µm to 6µm. Further preferably, the height of the first texture structures 21 ranges from 0µm to 3µm.

In some embodiments, the height of the second texture structures 31 ranges from 1µm to 10µm. For example, it can be 1µm, 2µm, 3µm, 4µm, 5µm, 6µm, 7µm, 8µm, 9µm or 10µm. Preferably, the height of the second texture structures 31 ranges from 1µm to 8µm. Further preferably, the height of the second texture structures 31 ranges from 1µm to 5µm.

Compared to the second texture structures 31, the first texture structures 21 are higher, which can effectively improve the passivation effect of the back surface of the cell, and improve the poor interface passivation effect between the semiconductor substrate 1 and the second passivation layer 6 on the back surface of the cell.

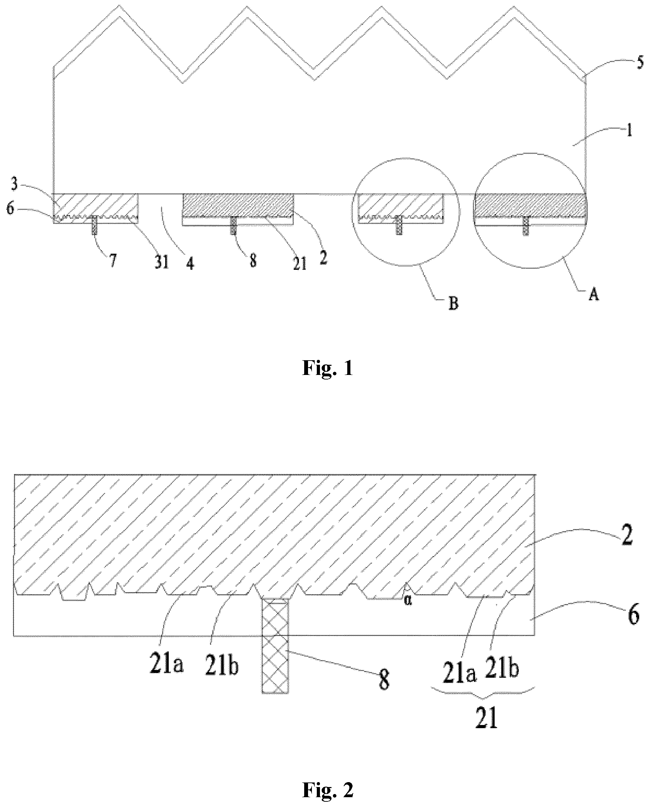

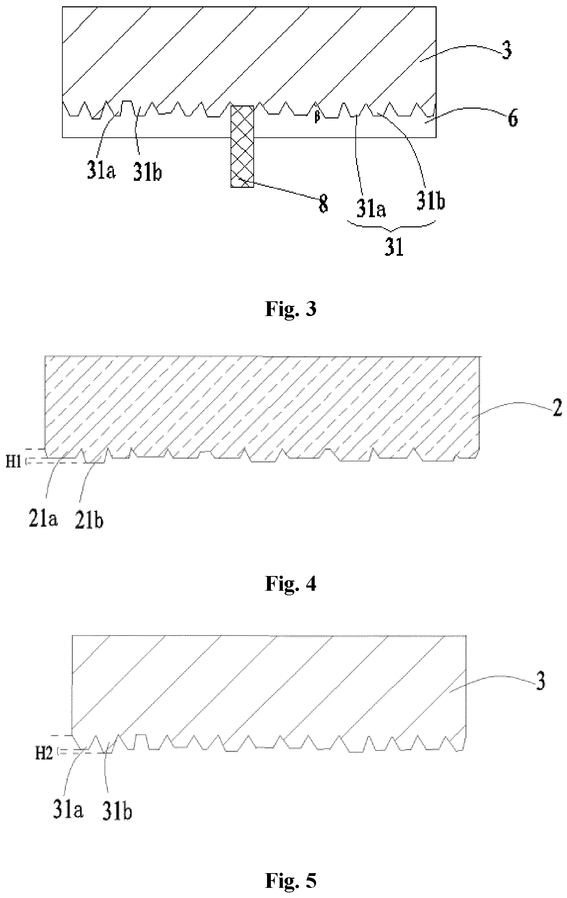

In some embodiments, Fig. 4 shows a schematic diagram of the first texture structures 21 in the N-type conductive region 2. Referring to Fig. 4, the two adjacent first texture structures 21 have a height difference H1 less than or equal to 1µm. For example, the height difference H1 can be 0.1µm, 0.3 µm, 0.5µm, 0.8µm or 1µm. The aforementioned specified range allows sunlight to irradiate within a portion of the N-type conductive region 2. Further, the height difference H1 between two adjacent first texture structures 21 can increase the number of reflections of the back reflected light, thereby enhancing the optical internal reflection effect of the back surface of the cell. If the height difference H1 between two adjacent first texture structures 21 is greater than 1 µm, it will increase the overall thickness of the cell on the one hand, and on the other hand, it will be detrimental to the subsequent deposition of film layers. Preferably, the height difference H1 is less than or equal to 500nm. It can be understood that within the N-type conductive region 2, any two adjacent first texture structures 21 may have a height difference H1, or some two adjacent first texture structures 21 may have a height difference H1. Referring to Figs. 2 and 4, the first texture structures 21 are not arranged on the surface of the N-type conductive region 2 to have a uniform height, but rather exhibit a high-low alternating arrangement.

In some embodiments, the N-type conductive region 2 includes a first N-type conductive region and a second N-type conductive region located on one side of the first N-type conductive region. The second N-type conductive region is located between the first N-type conductive region and the P-type conductive region 3. The height of the first texture structures 21 located within the first N-type conductive region is larger than the height of the first texture structures 21 located within the second N-type conductive region.

Since the N-type conductive region 2 and the P-type conductive region 3 are alternatingly arranged on the rear surface of the semiconductor substrate 1, the first N-type conductive region is located in the central region of the N-type conductive region 2, and the second N-type conductive region is located in the edge region of the N-type conductive region 2. It can be understood that the N-type conductive region 2 includes a central region and an edge region, and the edge region surrounds the central region. In the present disclosure, the sizes of the first texture structures 21 at different positions in the N-type conductive region 2 are particularly designed so that the first N-type conductive region, the second N-type conductive region and the P-type conductive region 3 are arranged in sequence, and the texture structures in the first N-type conductive region, the second N-type conductive region and the P-type conductive region 3 are arranged in a gradient manner. Therefore, in the process of preparing the solar cell, the back surface of the cell can obtain a higher internal reflection effect and excellent passivation performance, and it is also beneficial for the semiconductor substrate 1 to have better contact with the paste, thereby obtaining a higher open-circuit voltage and fill factor, and thus achieving higher cell conversion efficiency.

In some embodiments, Fig. 5 shows a schematic diagram of the second texture structures 31 in the P-type conductive region 3. Referring to Fig. 5, the two adjacent second texture structures 31 have a height difference H2 less than or equal to 1µm. For example, the height difference H2 can be 0.1µm, 0.3µm, 0.5µm, 0.8µm or 1µm. The aforementioned specified range allows sunlight to irradiate within a portion of the P-type conductive region 3. Further, the height difference between two adjacent second texture structures 31 can increase the number of reflections of the back reflected light, thereby enhancing the optical internal reflection effect of the back surface of the cell. If the height difference H2 between two adjacent second texture structures 31 is greater than 1µm, it will increase the overall thickness of the cell on the one hand, and on the other hand, it will be detrimental to the subsequent deposition of film layers. Preferably, the two adjacent second texture structures 31 have a height difference H2, which is less than or equal to 500nm. It can be understood that within the P-type conductive region 3, any two adjacent second texture structures 31 may have a height difference H2, or some two adjacent second texture structures 31 may have a height difference H2. Fig. 3 is an enlarged structural view of portion B in Fig. 1. Referring to Figs. 3 and 5, the second texture structures 31 are not arranged on the surface of the P-type conductive region 3 to have a uniform height, but rather exhibit a high-low alternating arrangement.

In some embodiments, the P-type conductive region 3 includes a first P-type conductive region and a second P-type conductive region located on one side of the first P-type conductive region. The second P-type conductive region is located between the first P-type conductive region and the N-type conductive region 2. The height of the second texture structures 31 located within the first P-type conductive region is larger than the height of the second texture structures 31 located within the second P-type conductive region.

Since the N-type conductive region 2 and the P-type conductive region 3 are alternatingly arranged on the rear surface of the semiconductor substrate 1, the first P-type conductive region is located in the central region of the P-type conductive region 3, and the second P-type conductive region is located in the edge region of the P-type conductive region 3. It can be understood that the P-type conductive region 3 includes a central region and an edge region, and the edge region surrounds the central region. In the present disclosure, the sizes of the second texture structures 31 at different positions in the P-type conductive region 3 are particularly designed so that the first P-type conductive region, the second P-type conductive region and the N-type conductive region 2 are arranged in sequence, and the texture structures in the first P-type conductive region, the second P-type conductive region and the N-type conductive region 2 are arranged in a gradient manner. Therefore, in the process of preparing the solar cell, the back surface of the cell can obtain a higher internal reflection effect and excellent passivation performance, and it is also beneficial for the semiconductor substrate 1 to have better contact with the paste, thereby obtaining a higher open-circuit voltage and fill factor, and thus achieving higher cell conversion efficiency.

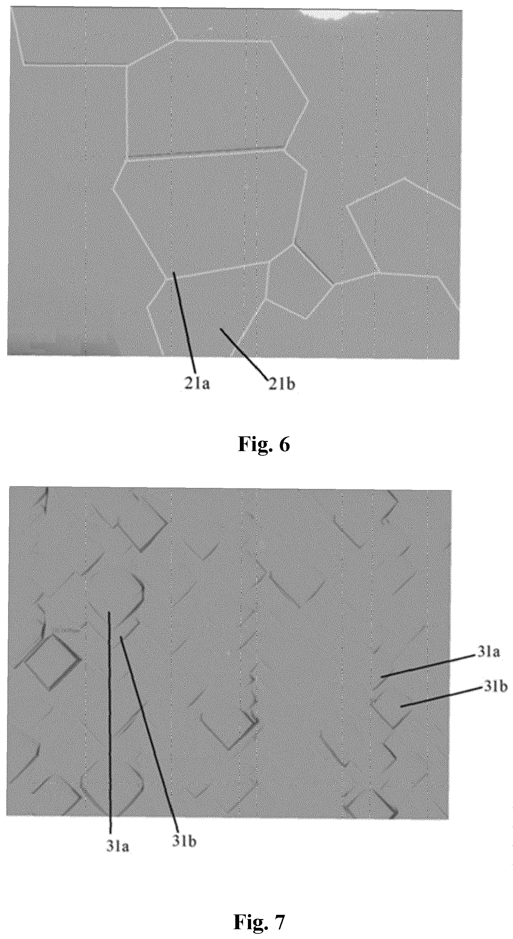

In some embodiments, Fig. 6 is a microscope image of the first texture structures 21 in the N-type conductive region 2. Referring again to Fig. 4 and Fig. 6, in the N-type conductive region 2, the first texture structures 21 include first substructures 21a and second substructures 21b adjacent to the first substructures 21a. The first substructures 21a and the second substructures 21b overlap partially, and there are gaps between some of the first substructures 21a and the second substructures 21b.

In the N-type conductive region 2, there are overlapping first substructures 21a and second substructures 21b, as well as non-overlapping first substructures 21a and second substructures 21b. The overlapping first substructures 21a and second substructures 21b can reduce the roughness of the rear surface of the semiconductor substrate 1. The non-overlapping first substructures 21a and second substructures 21b can increase the roughness of the rear surface of the semiconductor substrate 1. Moreover, whether the first substructures 21a and the second substructures 21b overlap also affects the internal reflection of sunlight at the N-type conductive region 2 on the rear surface of the semiconductor substrate 1. In the present disclosure, setting whether the first substructures 21a and the second substructures 21b overlap can control the roughness of the N-type conductive region 2 on the rear surface of the semiconductor substrate 1 within a desired range, which is beneficial to improving the passivation effect of the rear surface of the semiconductor substrate 1, and is also beneficial to the contact of electrode paste in the N-type conductive region 2, improving the open-circuit voltage and fill factor. It can also regulate the light absorption effect of the N-type conductive region 2 on the rear surface of the semiconductor substrate 1, so as to achieve a balance of various aspects of performance and obtain better overall performance of the cell.

In some embodiments, the first substructure 21a has a first side wall facing the second substructure 21b, and the second substructure 21b has a second side wall facing the first substructure 21a. There is a first angle between the first side wall and the second side wall. For example, the first angle is the angle α shown in Fig. 2. For the partially overlapping first substructures 21a and second substructures 21b, the size of the first angle can be used to characterize the size of the overlapping area between the first substructure 21a and second substructure 21b. In some cases, the greater the value of the first angle, the smaller the roughness of the surface on which the first substructure 21a and the second substructure 21b are located. The smaller the value of the first angle, the larger the roughness of the surface on which the first substructure 21a and the second substructure 21b are located. For the non-overlapping first substructures 21a and second substructures 21b, the size of the first angle does not necessarily affect the size of the gap between the first substructure 21a and second substructure 21b. In the present disclosure, the size of the first angle is controlled to control the roughness of the N-type conductive region 2 on the rear surface of the semiconductor substrate 1. It can be understood that for the partially overlapping first substructures 21a and second substructures 21b, the first angle is the angle between the first side wall and the second side wall. For the first substructures 21a and the second substructures 21b which are spaced apart, the first angle is the angle between the extension line of the first side wall and the extension line of the second side wall.

In some embodiments, the first angle ranges from 40° to 60°. For example, it can be 40°, 43°, 47°, 50°, 53°, 55°, 58°, or 60°. The aforementioned specified range allows the roughness of the N-type conductive region 2 on the rear surface of the semiconductor substrate 1 to be appropriate, and allows the N-type conductive region 2 on the rear surface of the semiconductor substrate 1 to have suitable light absorption capability and excellent passivation performance, which is beneficial to improving the overall performance of the cell. If the first angle is less than 40°, it indicates that the overlapping area between the first substructure 21a and the second substructure 21b is too large, which is detrimental to improving the internal reflection of the N-type conductive region 2 on the rear surface of the semiconductor substrate 1. If the first angle is greater than 60°, it indicates that the overlapping area between the first substructure 21a and the second substructure 21b is too small, which is detrimental to the subsequent deposition of film layers, resulting in poor passivation effect of the cell, poor contact characteristics of the paste, and thus reducing the open-circuit voltage and fill factor of the cell, thereby reducing the quality and yield rate of the cell. Preferably, the first angle ranges from 50° to 54°.

In some embodiments, Fig. 7 is a microscope image of the second texture structures 31 in the P-type conductive region 3. Referring again to Fig. 5 and Fig. 7, in the P-type conductive region 3, the second texture structures 31 include third substructures 31a and fourth substructures 31b adjacent to the third substructures 31a. The third substructures 31a and the fourth substructures 31b overlap partially, and there are gaps between some of the third substructures 21a and the fourth substructures 31b.

In the P-type conductive region 3, there are overlapping third substructures 31a and fourth substructures 31b, as well as non-overlapping third substructures 31a and fourth substructures 31b. The overlapping third substructures 31a and fourth substructures 31b can reduce the roughness of the rear surface of the semiconductor substrate 1. The non-overlapping third substructures 31a and fourth substructures 31b can increase the roughness of the rear surface of the semiconductor substrate 1. Moreover, whether the third substructures 31a and the fourth substructures 31b overlap also affects the internal reflection of sunlight at the N-type conductive region 2 on the rear surface of the semiconductor substrate 1. In the present disclosure, setting whether the third substructures 31a and the fourth substructures 31b overlap can control the roughness of the P-type conductive region 3 on the rear surface of the semiconductor substrate 1 within a desired range, which is beneficial to improving the passivation effect of the rear surface of the semiconductor substrate 1, and is also beneficial to the contact of electrode paste in the P-type conductive region 3. It can also regulate the light absorption effect of the P-type conductive region 3 on the rear surface of the semiconductor substrate 1, and improve the open-circuit voltage and fill factor. Thus, the cell can obtain excellent conversion efficiency. It can be understood that compared to the first texture structures 21, the height of the second texture structures 31 is smaller, and whether the third substructures 31a and the fourth substructures 31b overlap has a smaller impact on the light absorption of the rear surface of the semiconductor substrate 1.

In some embodiments, the third substructure 31a has a third side wall facing the fourth substructure 31b, and the fourth substructure 31b has a fourth side wall facing the third substructure 31a. There is a second angle between the third side wall and the fourth side wall. For example, the second angle is the angle β shown in Fig. 3. For the partially overlapping third substructures 31a and fourth substructures 31b, the size of the second angle can be used to characterize the size of the overlapping area between the third substructure 31a and fourth substructure 31b. In some cases, the greater the value of the second angle, the smaller the roughness of the surface on which the third substructure 31a and the fourth substructure 31b are located. The smaller the value of the second angle, the larger the roughness of the surface on which the third substructure 31a and the fourth substructure 31b are located. For the non-overlapping third substructures 31a and fourth substructures 31b, the size of the second angle does not necessarily affect the size of the gap between the third substructure 31a and fourth substructure 31b. In the present disclosure, the size of the second angle is controlled to control the roughness of the P-type conductive region 3 on the rear surface of the semiconductor substrate 1. It can be understood that for the partially overlapping third substructures 31a and fourth substructures 31b, the second angle is the angle between the third side wall and the fourth side wall. For the third substructures 31a and the fourth substructures 31b which are spaced apart, the second angle is the angle between the extension line of the third side wall and the extension line of the fourth side wall.

In some embodiments, the second angle ranges from 45° to 70°. For example, it can be 45°, 48°, 50°, 55°, 58°, 62°, 65°, or 70°. The aforementioned specified range allows the roughness of the P-type conductive region 3 on the rear surface of the semiconductor substrate 1 to be appropriate, and allows the P-type conductive region 3 on the rear surface of the semiconductor substrate 1 to have suitable light absorption capability and excellent passivation performance, which is beneficial to improving the overall performance of the cell. If the second angle is less than 45°, it indicates that the overlapping area between the third substructure 31a and the fourth substructure 31b is too large, which is detrimental to improving the internal reflection of the P-type conductive region 3 on the rear surface of the semiconductor substrate 1. If the second angle is greater than 60°, it indicates that the overlapping area between the third substructure 31a and the fourth substructure 31b is too small, which is detrimental to the subsequent deposition of film layers, resulting in poor passivation effect of the cell, poor contact characteristics of the paste, and thus reducing the open-circuit voltage and fill factor of the cell, thereby reducing the quality and yield rate of the cell. Preferably, the second angle ranges from 55° to 65°.

In some embodiments, the value of the first angle is less than the value of the second angle. It can be understood that the height of the first texture structures 21 of the N-type conductive region 2 is smaller than the height of the second texture structures 31 of the P-type conductive region 3, and the one-dimensional dimension of the first texture structures 21 is larger than the one-dimensional dimension of the second texture structures 31. For the first texture structures 21 and the second texture structures 31, when the value of the first angle is equal to that of the second angle, the volume of the overlapping portion of the first substructure 21a and the second substructure 21b is less than that of the overlapping portion of the third substructure 31a and the fourth substructure 31b. As a result, the P-type conductive region 3 and the N-type conductive region 2 differ significantly in the passivation performance and internal reflection ability. Therefore, according to the present disclosure, controlling the value of the first angle to be less than that of the second angle is beneficial to obtaining overall balance of the rear surface of the semiconductor substrate 1, thereby improving the comprehensive performance of the cell.

In some embodiments, the spacing between two adjacent N-type conductive regions 2 or between two adjacent P-type conductive regions 3 ranges from 0.5mm to 1.3mm. For example, it can be 0.5mm, 0.6mm, 0.7mm, 0.8mm, 0.9mm, 1.0mm, 1.1mm, 1.2mm, or 1.3mm.

In some embodiments, the distribution proportion of the N-type conductive regions 2 on the rear surface of the semiconductor substrate 1 ranges from 50% to 85%. For example, it can be 50%, 55%, 60%, 65%, 70%, 75%, 80% or 85%.

In some embodiments, the distribution proportion of the P-type conductive regions 3 on the rear surface of the semiconductor substrate 1 ranges from 15% to 50%. For example, it can be 15%, 20%, 25%, 30%, 35%, 40%, 45% or 50%.

The present disclosure defines the spacing between two adjacent N-type conductive regions 2 or between two adjacent P-type conductive regions 3 on the semiconductor substrate 1, and defines the distribution proportion respectively of N-type conductive regions 2 and P-type conductive regions 3 on the rear surface of the semiconductor substrate 1. During the preparation of solar cells, the above configuration can form PN junctions with excellent conductivity on the semiconductor substrate 1, thereby improving the photoelectric performance of the prepared solar cells.

In some embodiments, the preparation of the semiconductor substrate 1 of the present disclosure includes firstly preparing a backside structure with a large tower-like morphology by alkali polishing, depositing a corresponding film as the N-type conductive region 2, then determining the P-type conductive region by laser ablation, and then forming a planar surface morphology of small tower-like structure by removing laser damage using alkali polishing.

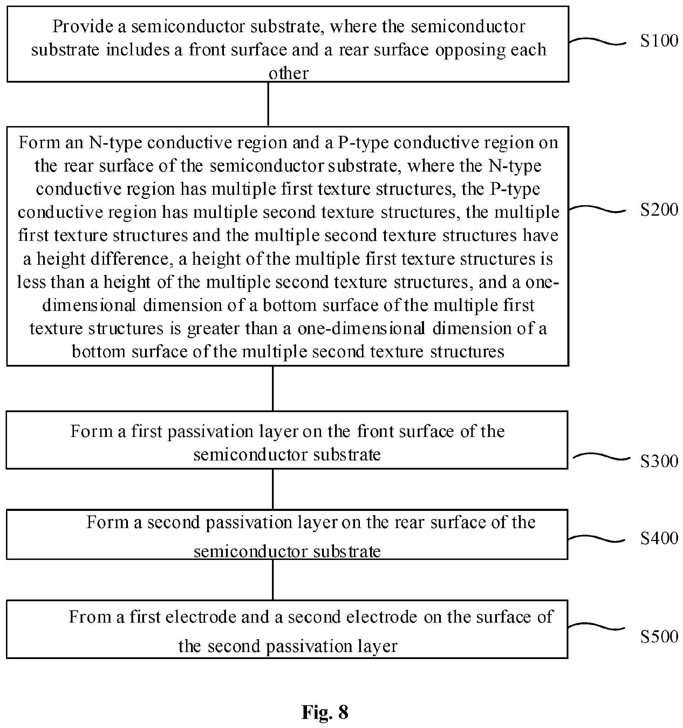

Embodiments of the present disclosure further provide a method for preparing the above-mentioned back contact solar cell. Fig. 8 shows a flow chart of the preparation of the back contact solar cell provided in an embodiment of the present disclosure. As shown in Fig. 8, the method for preparing the back contact solar cell includes the following operations: providing a semiconductor substrate 1, where the semiconductor substrate 1 includes a front surface and a rear surface opposing each other; where the rear surface of the semiconductor substrate 1 is formed with an N-type conductive region 2 and a P-type conductive region 3, the N-type conductive region 2 has a plurality of first texture structures 21, the P-type conductive region 3 has a plurality of second texture structures 31, the first texture structures 21 include two adjacent first texture structures 21 that are different at least in height, the second texture structures 31 include two adjacent second texture structures 31 that are different at least in height, a height of the first texture structures 21 is less than a height of the second texture structures 31, and a one-dimensional dimension of the first texture structures 21 is greater than a one-dimensional dimension of the second texture structures 31; forming a first passivation layer 5 on the front surface of the semiconductor substrate 1; forming a second passivation layer 6 on the rear surface of the semiconductor substrate 1; and forming a first electrode 7 and a second electrode 8 on the surface of the second passivation layer 6.

The method for preparing the back contact solar cell 100 of the present disclosure will be described clearly and completely hereinafter in conjunction with the drawings in the embodiments of the present disclosure. Apparently, the described embodiments are only a part of the embodiments of the present disclosure, rather than all embodiments.

In operation S100, a semiconductor substrate 1 is provided, where the semiconductor substrate 1 includes a front surface and a rear surface opposing each other.

In some embodiments, the front surface of the semiconductor substrate 1 corresponds to the front surface of the cell, which is the surface facing the sun (i.e., the light-receiving surface), and the rear surface of the semiconductor substrate 1 corresponds to the back surface of the cell, which is the surface facing away from the sun (i.e., the back surface).

In some embodiments, the semiconductor substrate 1 is an N-type crystalline silicon substrate (or silicon wafer), and may also be a P-type crystalline silicon substrate (silicon wafer). The crystalline silicon substrate (silicon substrate) is, for example, one of polycrystalline silicon substrate, monocrystalline silicon substrate, microcrystalline silicon substrate, or silicon carbide substrate. The specific type of the semiconductor substrate 1 is not limited in the embodiments of the present disclosure.

In some embodiments, the thickness of the semiconductor substrate 1 ranges from 60µm to 240µm. For example, it can be 60µm, 80µm, 90µm, 100µm, 120µm, 150µm, 200µm, or 240µm, which is not limited here.

In operation S200, a P-type conductive region 3 and an N-type conductive region 2 are formed on the rear surface of the semiconductor substrate 1.

In operation S201, pickling is performed on the rear surface of the semiconductor substrate 1, and then a first polishing process is performed on the rear surface of the semiconductor substrate 1 with a first alkali solution, so that first texture structures 21 are formed on the rear surface of the semiconductor substrate 1.

In operation S202, a P-type conductive region 3 is determined and formed by laser ablation, the region formed with the first texture structures 21 are taken as an N-type conductive region 2, and then a second polishing process is performed on the P-type conductive region 3 on the rear surface of the semiconductor substrate 1 with a second alkali solution to form second texture structures 31 in the P-type conductive region 3, so that the height of the first texture structures 21 and the height of the second texture structures 31 are different, the height of the first texture structures 21 is smaller than the height of the second texture structures 31, and the one-dimensional dimension of the first texture structures 21 is larger than the one-dimensional dimension of the second texture structures 31.

In operations S201 and S202, the duration of the first polishing process and the duration of the second polishing process can be controlled to be different; and/or the concentration of the first alkali solution and the concentration of the second alkali solution are controlled to be different, so that the first texture structures 21 differ from the second texture structures 31 in size and morphology.

In some embodiments, the first and/or second alkali solution is a sodium hydroxide solution.

In operation S300, a first passivation layer 5 is formed on the front surface of the semiconductor substrate 1.

In the present disclosure, a first passivation layer 5 is formed on the front surface of the semiconductor substrate 1. The first passivation layer 5 can reduce the surface minority carrier concentration of the semiconductor substrate 1 through passivation effects, suppress carrier recombination on the cell surface, thereby reducing the surface recombination rate, reducing the series resistance and enhancing the electron transport capability.

In some embodiments, the first passivation layer 5 may include, but not limited to, a single-layer oxide layer or a multi-layer structure of silicon oxide, silicon nitride, silicon oxynitride, and aluminum oxide. Other types of passivation layers may also be used. The specific material of the first passivation layer 5 is not limited in the present disclosure. The first passivation layer 5 can produce good passivation and anti-reflection effects on the semiconductor substrate 1, which helps to improve the conversion efficiency of the cell.

In some embodiments, the thickness of the first passivation layer 5 ranges from 10nm to 100nm. For example, it can be 10nm, 20nm, 30nm, 42nm, 50nm, 60nm, 70nm, 80nm, 90nm or 100nm. Of course, it can also be other values within the above ranges, which is not limited here.

In some embodiments, the preparation method of the present disclosure further includes: forming an anti-reflection layer on the surface of the first passivation layer 5 to reduce light reflection on the front surface of the cell.

In some embodiments, the anti-reflection layer may be a silicon oxynitride layer, or an aluminum oxide/silicon nitride stacked-layer structure, which is not limited in the present disclosure. Taking the silicon oxynitride layer as an example, the presence of silicon oxynitride can effectively reduce light reflection and improve light transmittance. Controlling the thickness of the film can adjust its reflectivity to achieve the desired anti-reflection effect. Moreover, the raw material NH4 of silicon oxynitride will decompose to release H atoms during the reaction process, and the H atoms will penetrate into the semiconductor substrate 1 at high temperatures and combine with the dangling bonds on the surface to play a passivation role.

In some embodiments, the thickness of the first passivation layer 5 ranges from 40nm to 100nm. For example, it can be 40nm, 50nm, 60nm, 70nm, 80nm, 90nm or 100nm. Of course, it can also be other values within the above range, which is not limited here.

In some embodiments, the first passivation layer 5 and/or anti-reflection layer can be deposited using plasma-enhanced chemical vapor deposition. Other methods such as organic chemical vapor deposition are also applicable. The specific implementation of the first passivation layer 5 in the embodiments of the present disclosure is not limited.

In operation S400, a second passivation layer 6 is formed on the rear surface of the semiconductor substrate 1.

In some embodiments, the second passivation layer 6 includes any one or a combination of silicon nitride layer, silicon oxynitride layer, and aluminum oxide/silicon nitride stacked-layer structure. Of course, other types of passivation layers can also be used for the second passivation layer 6. The specific material of the second passivation layer 6 is not limited in the present disclosure. For example, in other embodiments, the second passivation layer 6 may also be a stacked layer of silicon dioxide and silicon nitride. The second passivation layer 6 can produce a good passivation effect on the silicon substrate, which helps to improve the conversion efficiency of the cell.

In some embodiments, the second passivation layer 6 can be deposited using plasma-enhanced chemical vapor deposition. Other methods such as organic chemical vapor deposition are also applicable.

In some embodiments, the thickness of the second passivation layer 6 ranges from 10nm to 100nm. For example, it can be 10nm, 20nm, 30nm, 42nm, 50nm, 60nm, 70nm, 80nm, 90nm or 100nm. Of course, it can also be other values within the above range, which is not limited here.

In operation S500, a first electrode 7 and a second electrode 8 are formed on the surface of the second passivation layer 6. A back contact solar cell is obtained, and the structural schematic diagram of the back contact solar cell is shown in Fig. 1.

Specifically, in this operation, the first electrode 7 and the second electrode 8 are obtained by performing metallization treatment on the surface of the second passivation layer 6, and the first electrode 7 and the second electrode 8 correspond to the P-type conductive region 3 and the N-type conductive region 2, respectively. The first electrode 7 and the second electrode 8 can be prepared using screen printing and then sintering. This allows the first electrode 7 to form an ohmic contact with the N-type conductive region 2 through the second passivation layer 6, and the second electrode 8 to form an ohmic contact with the P-type conductive region 3 through the second passivation layer 6; or, allows the first electrode 7 to form an ohmic contact with the P-type conductive region 3 through the second passivation layer 6, and the second electrode 8 to form an ohmic contact with the N-type conductive region 2 through the second passivation layer 6. Of course, at least one of metal evaporation and electroplating can also be used to form the first electrode 7 and the second electrode 8 on the rear surface of the cell.

It should be noted that the specific materials of the first electrode 7 and the second electrode 8 are not limited in the embodiments of the present disclosure. For example, when the first electrode 7 forms an ohmic contact with the P-type conductive region 3 and the second electrode 8 forms an ohmic contact with the N-type conductive region 2, the first electrode 7 is a silver electrode or a silver/aluminum electrode, and the second electrode 8 is a silver electrode. For example, silver paste can be printed on the lower surface of the second passivation layer 6 corresponding to the N-type conductive region 2, and silver paste or silver/aluminum paste doped with a small amount of aluminum can be printed on the lower surface of the second passivation layer 6 corresponding to the P-type conductive region 3. After sintering, each paste can burn through the second passivation layer 6. The formed silver electrode or silver/aluminum electrode forms an ohmic contact with the P-type conductive region 3, and the formed silver electrode forms an ohmic contact with the N-type conductive region 2.

It should be noted that in the present disclosure, unless otherwise specified, the above operations can be performed in the above sequence or in another applicable sequence. The sequence of operations for preparing solar cells in the embodiments of the present disclosure is not limited, and can be adjusted according to the actual production process.

The embodiments of the present disclosure provide a photovoltaic module 1000, which includes a cell string formed by electrically connecting the aforementioned back contact solar cells.

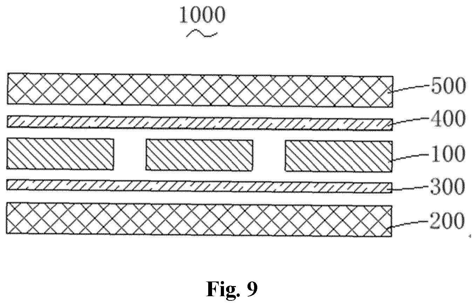

Specifically, referring to Fig. 9, the photovoltaic module 1000 includes a first cover plate 200, a first encapsulation adhesive layer 300, a solar cell string, a second encapsulation adhesive layer 400, and a second cover plate 500.

In some embodiments, the solar cell string includes a plurality of back contact solar cells 100 as described above connected by conductive ribbons. The connection between the back contact solar cells 100 can be partial overlapping or splicing.

In some embodiments, the first cover plate 200 and the second cover plate 500 may be transparent or opaque cover plates, such as glass cover plates or plastic cover plates.

Two sides of the first encapsulation adhesive layer 300 are respectively in contact with the first cover plate 200 and the cell string, and two sides of the second encapsulation adhesive layer 400 are respectively in contact with the second cover plate 500 and the cell string. The first encapsulation adhesive layer 300 and the second encapsulation adhesive layer 400 may be made of ethylene-vinyl acetate copolymer (EVA) adhesive film, polyolefin elastomer (POE) adhesive film, or polyethylene glycol terephthalate (PET) adhesive film.

The photovoltaic module 1000 may adopt a side-enclosed encapsulation method, in which the sides of the photovoltaic module 1000 are completely wrapped and encapsulated with encapsulation tape to prevent the phenomenon of lamination deviation during the lamination process.

The photovoltaic module 1000 further includes an edge sealing component that is sealingly fixed to a portion of the edge of the photovoltaic module 1000. The edge sealing component may be sealingly fixed on the edge near the corner of the photovoltaic module 1000. The edge sealing component may be a high-temperature resistant tape. The high-temperature resistant tape has excellent high-temperature resistance characteristics, and does not decompose or fall off during the lamination process, ensuring reliable encapsulation of the photovoltaic module 1000. Two ends of the high-temperature resistant tape are respectively fixed to the second cover plate 500 and the first cover plate 200. The two ends of the high-temperature resistant tape may be adhered to the second cover plate 500 and the first cover plate 200 respectively, while the middle part thereof can limit the sides of the photovoltaic module 1000 and prevent the photovoltaic module 1000 from lamination deviation during the lamination process.

## Claims

1. A back contact solar cell (100), comprising:
a semiconductor substrate (1) having a front surface and a rear surface opposing each other, wherein an N-type conductive region (2) and a P-type conductive region (3) are arranged on the rear surface of the semiconductor substrate (1), the N-type conductive region (2) has a plurality of first texture structures (21), the P-type conductive region (3) has a plurality of second texture structures (31), the plurality of first texture structures (21) include two adjacent first texture structures (21) that are different at least in height, the plurality of second texture structures (31) include two adjacent second texture structures (31) that are different at least in height, an average of the height of the plurality of first texture structures (21) is less than an average of the height of the plurality of second texture structures (31), and an average of a one-dimensional dimension of the plurality of first texture structures (21) is greater than an average of a one-dimensional dimension of the plurality of second texture structures (31), wherein the one-dimensional dimension of the plurality of first texture structures (21) refers to a length, width, diagonal length or diameter of a circle, of a bottom surface of the plurality of first texture structures (21), and the one-dimensional dimension of the plurality of second texture structures (31) refers to a length, width, diagonal length or diameter of a circle, of a bottom surface of the plurality of second texture structures (31);
a first passivation layer (5) located on the front surface of the semiconductor substrate (1);
a second passivation layer (6) located on the rear surface of the semiconductor substrate (1);
a first electrode (7) passing through the second passivation layer (6) and forming an ohmic contact with the P-type conductive region (3); and
a second electrode (8) passing through the second passivation layer (6) and forming an ohmic contact with the N-type conductive region (2).

2. The back contact solar cell (100) according to claim 1, wherein the one-dimensional dimension of the plurality of first texture structures (21) is less than or equal to 40nm.

3. The back contact solar cell (100) according to claim 1, wherein the one-dimensional dimension of the plurality of second texture structures (31) is less than or equal to 30nm.

4. The back contact solar cell (100) according to claim 1, wherein the two adjacent first texture structures (21) have a height difference less than or equal to 1µm.

5. The back contact solar cell (100) according to claim 1, wherein the N-type conductive region (2) comprises a first N-type conductive region (2) and a second N-type conductive region (2) located on one side of the first N-type conductive region (2), wherein the second N-type conductive region (2) is located between the first N-type conductive region (2) and the P-type conductive region (3), and the height of the first texture structures (21) located within the first N-type conductive region (2) is larger than the height of the first texture structures (21) located within the second N-type conductive region (2).

6. The back contact solar cell (100) according to claim 1, wherein the two adjacent second texture structures (31) have a height difference less than or equal to 1µm.

7. The back contact solar cell (100) according to claim 1, wherein the P-type conductive region (3) comprises a first P-type conductive region (3) and a second P-type conductive region (3) located on one side of the first P-type conductive region (3), wherein the second P-type conductive region (3) is located between the first P-type conductive region (3) and the N-type conductive region (2), and the height of the second texture structures (31) located within the first P-type conductive region (3) is larger than the height of the second texture structures (31) located within the second P-type conductive region (3).

8. The back contact solar cell (100) according to claim 1, wherein in the N-type conductive region (2), the plurality of first texture structures (21) comprise first substructures (21a) and second substructures (21b) adjacent to the first substructures (21a), wherein the first substructures (21a) and the second substructures (21b) overlap partially, and there are gaps between some of the first substructures (21a) and the second substructures (21b);
each of the first substructures (21a) has a first side wall facing the second substructures (21b), and each of the second substructures (21b) has a second side wall facing the first substructures (21a), wherein there is a first angle between the first side wall and the second side wall.

9. The back contact solar cell (100) according to claim 1, wherein in the P-type conductive region (3), the plurality of second texture structures (31) comprise third substructures (31a) and fourth substructures (31b) adjacent to the third substructures (31a), wherein the third substructures (31a) and the fourth substructures (31b) overlap partially, and there are gaps between some of the third substructures (31a) and the fourth substructures (31b);
each of the third substructures (31a) has a third side wall facing the fourth substructures (31b), and each of the fourth substructures (31b) has a fourth side wall facing the third substructures (31a), wherein there is a second angle between the third side wall and the fourth side wall.

10. The back contact solar cell (100) according to claim 9, wherein the value of the first angle is less than or equal to the value of the second angle; and/or the first angle ranges from 40° to 60°; and/or the second angle ranges from 45° to 70°.

11. The back contact solar cell (100) according to claim 1, wherein a spacing between two adjacent N-type conductive region (2)s or between two adjacent P-type conductive region (3)s ranges from 0.5mm to 1.3mm; a distribution proportion of the N-type conductive region (2)s on the rear surface of the semiconductor substrate (1) ranges from 50% to 85%; and a distribution proportion of the P-type conductive region (3)s on the rear surface of the semiconductor substrate (1) ranges from 15% to 50%.

12. The back contact solar cell (100) according to claim 1, wherein a morphology of the first texture structures (21) and/or the second texture structures (31) comprises a non-pyramid shape.

13. The back contact solar cell (100) according to claim 1, wherein the morphology of the bottom surface of the first texture structures (21) and the second texture structures (31) comprise at least one of diamond, square, trapezoid, approximate diamond, approximate square, and approximate trapezoid.

14. A photovoltaic module, comprising: at least one cover plate, at least one encapsulation material layer, and at least one solar cell string comprising at least one back contact solar cell (100) according to any one of claims 1 to 13.

## Patentansprüche

1. Rückkontaktsolarzelle (100), umfassend:
ein Halbleitersubstrat (1) mit einer Vorderfläche und einer Rückfläche, die einander gegenüberliegen, wobei ein n-leitender Bereich (2) und ein p-leitender Bereich (3) auf der Rückfläche des Halbleitersubstrats (1) angeordnet sind, der n-leitende Bereich (2) eine Vielzahl von ersten Texturstrukturen (21) aufweist, der p-leitende Bereich (3) eine Vielzahl von zweiten Texturstrukturen (31) aufweist, die Vielzahl von ersten Texturstrukturen (21) zwei benachbarte erste Texturstrukturen (21) umfasst, die sich zumindest in der Höhe unterscheiden, die Vielzahl von zweiten Texturstrukturen (31) zwei benachbarte zweite Texturstrukturen (31) umfasst, die sich zumindest in der Höhe unterscheiden, ein Mittelwert der Höhe der Vielzahl von ersten Texturstrukturen (21) kleiner ist als ein Mittelwert der Höhe der Vielzahl von zweiten Texturstrukturen (31), und ein Mittelwert einer eindimensionalen Abmessung der Vielzahl von ersten Texturstrukturen (21) größer ist als ein Mittelwert einer eindimensionalen Abmessung der Vielzahl von zweiten Texturstrukturen (31), wobei sich die eindimensionale Abmessung der Vielzahl von ersten Texturstrukturen (21) auf eine Länge, eine Breite, eine Diagonallänge oder einen Durchmesser eines Kreises, einer Unterseite der Vielzahl von ersten Texturstrukturen (21), bezieht, und sich die eindimensionale Abmessung der Vielzahl von zweiten Texturstrukturen (31) auf eine Länge, eine Breite, eine Diagonallänge oder einen Durchmesser eines Kreises, einer Unterseite der Vielzahl von zweiten Texturstrukturen (31), bezieht;
eine erste Passivierungsschicht (5), die sich auf der Vorderfläche des Halbleitersubstrats (1) befindet;
eine zweite Passivierungsschicht (6), die sich auf der Rückfläche des Halbleitersubstrats (1) befindet;
eine erste Elektrode (7), die durch die zweite Passivierungsschicht (6) hindurchtritt und einen ohmschen Kontakt mit dem p-leitenden Bereich (3) bildet; und
eine zweite Elektrode (8), die durch die zweite Passivierungsschicht (6) hindurchtritt und einen ohmschen Kontakt mit dem n-leitenden Bereich (2) bildet.

2. Rückkontaktsolarzelle (100) nach Anspruch 1, wobei die eindimensionale Abmessung der Vielzahl von ersten Texturstrukturen (21) kleiner als oder gleich 40 nm ist.

3. Rückkontaktsolarzelle (100) nach Anspruch 1, wobei die eindimensionale Abmessung der Vielzahl von zweiten Texturstrukturen (31) kleiner als oder gleich 30 nm ist.

4. Rückkontaktsolarzelle (100) nach Anspruch 1, wobei die zwei benachbarten ersten Texturstrukturen (21) eine Höhendifferenz kleiner als oder gleich 1 µm aufweisen.

5. Rückkontaktsolarzelle (100) nach Anspruch 1, wobei der n-leitende Bereich (2) einen ersten n-leitenden Bereich (2) und einen zweiten n-leitenden Bereich (2), der sich auf einer Seite des ersten n-leitenden Bereichs (2) befindet, umfasst, wobei sich der zweite n-leitende Bereich (2) zwischen dem ersten n-leitenden Bereich (2) und dem p-leitenden Bereich (3) befindet, und die Höhe der ersten Texturstrukturen (21), die sich innerhalb des ersten n-leitenden Bereichs (2) befinden, größer ist als die Höhe der ersten Texturstrukturen (21), die sich innerhalb des zweiten n-leitenden Bereichs (2) befinden.

6. Rückkontaktsolarzelle (100) nach Anspruch 1, wobei die zwei benachbarten zweiten Texturstrukturen (31) eine Höhendifferenz kleiner als oder gleich 1 µm aufweisen.

7. Rückkontaktsolarzelle (100) nach Anspruch 1, wobei der p-leitende Bereich (3) einen ersten p-leitenden Bereich (3) und einen zweiten p-leitenden Bereich (3), der sich auf einer Seite des ersten p-leitenden Bereichs (3) befindet, umfasst, wobei sich der zweite p-leitende Bereich (3) zwischen dem ersten p-leitenden Bereich (3) und dem n-leitenden Bereich (2) befindet, und die Höhe der zweiten Texturstrukturen (31), die sich innerhalb des ersten p-leitenden Bereichs (3) befinden, größer ist als die Höhe der zweiten Texturstrukturen (31), die sich innerhalb des zweiten p-leitenden Bereichs (3) befinden.

8. Rückkontaktsolarzelle (100) nach Anspruch 1, wobei in dem n-leitenden Bereich (2) die Vielzahl von ersten Texturstrukturen (21) erste Teilstrukturen (21a) und zweite Teilstrukturen (21b), die zu den ersten Teilstrukturen (21a) benachbart sind, umfasst, wobei sich die ersten Teilstrukturen (21a) und die zweiten Teilstrukturen (21b) teilweise überlappen, und Zwischenräume zwischen einigen der ersten Teilstrukturen (21a) und der zweiten Teilstrukturen (21b) vorhanden sind;
jede der ersten Teilstrukturen (21a) eine erste Seitenwand aufweist, die den zweiten Teilstrukturen (21b) zugewandt ist, und jede der zweiten Teilstrukturen (21b) eine zweite Seitenwand aufweist, die den ersten Teilstrukturen (21a) zugewandt ist, wobei ein erster Winkel zwischen der ersten Seitenwand und der zweiten Seitenwand vorhanden ist.

9. Rückkontaktsolarzelle (100) nach Anspruch 1, wobei in dem p-leitenden Bereich (3) die Vielzahl von zweiten Texturstrukturen (31) dritte Teilstrukturen (31a) und vierte Teilstrukturen (31b), die zu den dritten Teilstrukturen (31a) benachbart sind, umfasst, wobei sich die dritten Teilstrukturen (31a) und die vierten Teilstrukturen (31b) teilweise überlappen, und Zwischenräume zwischen einigen der dritten Teilstrukturen (31a) und der vierten Teilstrukturen (31b) vorhanden sind;
jede der dritten Teilstrukturen (31a) eine dritte Seitenwand aufweist, die den vierten Teilstrukturen (31b) zugewandt ist, und jede der vierten Teilstrukturen (31b) eine vierte Seitenwand aufweist, die den dritten Teilstrukturen (31a) zugewandt ist, wobei ein zweiter Winkel zwischen der dritten Seitenwand und der vierten Seitenwand vorhanden ist.

10. Rückkontaktsolarzelle (100) nach Anspruch 9, wobei der Wert des ersten Winkels kleiner als oder gleich dem Wert des zweiten Winkels ist; und/oder der erste Winkel im Bereich von 40° bis 60° liegt; und/oder der zweite Winkel im Bereich von 45° bis 70° liegt.

11. Rückkontaktsolarzelle (100) nach Anspruch 1, wobei ein Abstand zwischen zwei benachbarten n-leitenden Bereichen (2) oder zwischen zwei benachbarten p-leitenden Bereichen (3) im Bereich von 0,5 mm bis 1,3 mm liegt; ein Verteilungsanteil der n-leitenden Bereiche (2) auf der Rückfläche des Halbleitersubstrats (1) im Bereich von 50 % bis 85 % liegt; und ein Verteilungsanteil der p-leitenden Bereiche (3) auf der Rückfläche des Halbleitersubstrats (1) im Bereich von 15 % bis 50 % liegt.

12. Rückkontaktsolarzelle (100) nach Anspruch 1, wobei eine Morphologie der ersten Texturstrukturen (21) und/oder der zweiten Texturstrukturen (31) eine nichtpyramidenförmige Form umfasst.

13. Rückkontaktsolarzelle (100) nach Anspruch 1, wobei die Morphologie der Unterseite der ersten Texturstrukturen (21) und der zweiten Texturstrukturen (31) mindestens eines von einer Raute, einem Quadrat, einem Trapez, einer angenäherten Raute, einem angenäherten Quadrat und einem angenäherten Trapez umfasst.

14. Photovoltaikmodul, umfassend: mindestens eine Deckplatte, mindestens eine Verkapselungsmaterialschicht und mindestens einen Solarzellenstrang, der mindestens eine Rückkontaktsolarzelle (100) nach einem der Ansprüche 1 bis 13 umfasst.

## Revendications

1. Cellule solaire à contact arrière (100), comprenant :
un substrat semi-conducteur (1) ayant une surface avant et une surface arrière opposées l'une à l'autre, dans laquelle une région conductrice de type N (2) et une région conductrice de type P (3) sont agencées sur la surface arrière du substrat semi-conducteur (1), la région conductrice de type N (2) présente une pluralité de premières structures de texture (21), la région conductrice de type P (3) présente une pluralité de deuxièmes structures de texture (31), la pluralité de premières structures de texture (21) comprend deux premières structures de texture (21) adjacentes qui diffèrent au moins en hauteur, la pluralité de deuxièmes structures de texture (31) comprend deux deuxièmes structures de texture (31) adjacentes qui diffèrent au moins en hauteur, une moyenne de la hauteur de la pluralité de premières structures de texture (21) est inférieure à une moyenne de la hauteur de la pluralité de deuxièmes structures de texture (31), et une moyenne d'une dimension unidimensionnelle de la pluralité de premières structures de texture (21) est supérieure à une moyenne d'une dimension unidimensionnelle de la pluralité de deuxièmes structures de texture (31), dans laquelle la dimension unidimensionnelle de la pluralité de premières structures de texture (21) se réfère à une longueur, une largeur, une longueur diagonale ou un diamètre d'un cercle, d'une surface inférieure de la pluralité de premières structures de texture (21), et la dimension unidimensionnelle de la pluralité de deuxièmes structures de texture (31) se réfère à une longueur, une largeur, une longueur diagonale ou un diamètre d'un cercle, d'une surface inférieure de la pluralité de deuxièmes structures de texture (31) ;
une première couche de passivation (5) située sur la surface avant du substrat semi-conducteur (1) ;
une deuxième couche de passivation (6) située sur la surface arrière du substrat semi-conducteur (1) ;
une première électrode (7) traversant la deuxième couche de passivation (6) et formant un contact ohmique avec la région conductrice de type P (3) ; et
une deuxième électrode (8) traversant la deuxième couche de passivation (6) et formant un contact ohmique avec la région conductrice de type N (2).

2. Cellule solaire à contact arrière (100) selon la revendication 1, dans laquelle la dimension unidimensionnelle de la pluralité de premières structures de texture (21) est inférieure ou égale à 40 nm.

3. Cellule solaire à contact arrière (100) selon la revendication 1, dans laquelle la dimension unidimensionnelle de la pluralité de deuxièmes structures de texture (31) est inférieure ou égale à 30 nm.

4. Cellule solaire à contact arrière (100) selon la revendication 1, dans laquelle les deux premières structures de texture (21) adjacentes présentent une différence de hauteur inférieure ou égale à 1 µm.

5. Cellule solaire à contact arrière (100) selon la revendication 1, dans laquelle la région conductrice de type N (2) comprend une première région conductrice de type N (2) et une deuxième région conductrice de type N (2) située d'un côté de la première région conductrice de type N (2), dans laquelle la deuxième région conductrice de type N (2) est située entre la première région conductrice de type N (2) et la région conductrice de type P (3), et la hauteur des premières structures de texture (21) situées à l'intérieur de la première région conductrice de type N (2) est supérieure à la hauteur des premières structures de texture (21) situées à l'intérieur de la deuxième région conductrice de type N (2).

6. Cellule solaire à contact arrière (100) selon la revendication 1, dans laquelle les deux deuxièmes structures de texture (31) adjacentes présentent une différence de hauteur inférieure ou égale à 1 µm.

7. Cellule solaire à contact arrière (100) selon la revendication 1, dans laquelle la région conductrice de type P (3) comprend une première région conductrice de type P (3) et une deuxième région conductrice de type P (3) située d'un côté de la première région conductrice de type P (3), dans laquelle la deuxième région conductrice de type P (3) est située entre la première région conductrice de type P (3) et la région conductrice de type N (2), et la hauteur des deuxièmes structures de texture (31) situées à l'intérieur de la première région conductrice de type P (3) est supérieure à la hauteur des deuxièmes structures de texture (31) situées à l'intérieur de la deuxième région conductrice de type P (3).

8. Cellule solaire à contact arrière (100) selon la revendication 1, dans laquelle, dans la région conductrice de type N (2), la pluralité de premières structures de texture (21) comprend des premières sous-structures (21a) et des deuxièmes sous-structures (21b) adjacentes aux premières sous-structures (21a), dans laquelle les premières sous-structures (21a) et les deuxièmes sous-structures (21b) se chevauchent partiellement, et il existe des espaces entre certaines des premières sous-structures (21a) et des deuxièmes sous-structures (21b) ;
chacune des premières sous-structures (21a) présente une première paroi latérale faisant face aux deuxièmes sous-structures (21b), et chacune des deuxièmes sous-structures (21b) présente une deuxième paroi latérale faisant face aux premières sous-structures (21a), dans laquelle il existe un premier angle entre la première paroi latérale et la deuxième paroi latérale.

9. Cellule solaire à contact arrière (100) selon la revendication 1, dans laquelle, dans la région conductrice de type P (3), la pluralité de deuxièmes structures de texture (31) comprend des troisièmes sous-structures (31a) et des quatrièmes sous-structures (31b) adjacentes aux troisièmes sous-structures (31a), dans laquelle les troisièmes sous-structures (31a) et les quatrièmes sous-structures (31b) se chevauchent partiellement, et il existe des espaces entre certaines des troisièmes sous-structures (31a) et des quatrièmes sous-structures (31b) ;
chacune des troisièmes sous-structures (31a) présente une troisième paroi latérale faisant face aux quatrièmes sous-structures (31b), et chacune des quatrièmes sous-structures (31b) présente une quatrième paroi latérale faisant face aux troisièmes sous-structures (31a), dans laquelle il existe un deuxième angle entre la troisième paroi latérale et la quatrième paroi latérale.

10. Cellule solaire à contact arrière (100) selon la revendication 9, dans laquelle la valeur du premier angle est inférieure ou égale à la valeur du deuxième angle ; et/ou le premier angle est compris entre 40° et 60° ; et/ou le deuxième angle est compris entre 45° et 70°.

11. Cellule solaire à contact arrière (100) selon la revendication 1, dans laquelle un espacement entre deux régions conductrices de type N (2) adjacentes ou entre deux régions conductrices de type P (3) adjacentes est compris entre 0,5 mm et 1,3 mm ; une proportion de distribution des régions conductrices de type N (2) sur la surface arrière du substrat semi-conducteur (1) est comprise entre 50 % et 85 % ; et une proportion de distribution des régions conductrices de type P (3) sur la surface arrière du substrat semi-conducteur (1) est comprise entre 15 % et 50 %.

12. Cellule solaire à contact arrière (100) selon la revendication 1, dans laquelle une morphologie des premières structures de texture (21) et/ou des deuxièmes structures de texture (31) comprend une forme non pyramidale.

13. Cellule solaire à contact arrière (100) selon la revendication 1, dans laquelle la morphologie de la surface inférieure des premières structures de texture (21) et des deuxièmes structures de texture (31) comprend au moins l'une parmi un losange, un carré, un trapèze, un losange approximatif, un carré approximatif et un trapèze approximatif.

14. Module photovoltaïque, comprenant : au moins une plaque de couverture, au moins une couche de matériau d'encapsulation, et au moins une chaîne de cellules solaires comprenant au moins une cellule solaire à contact arrière (100) selon l'une quelconque des revendications 1 à 13.
